# EUROPEAN PATENT APPLICATION

(11) **EP 4 811 941 A1**
(43) Date of publication of application: **23.09.2026**
(21) Application number: 26155416.6
(22) Date of filing: 30.01.2026
(51) Int. Cl.: H05K 7/18, A47B 46/00, A47B 21/04, A47B 88/42

(54) **RACK CABINET WITH REMOVABLE INTERIOR STRUCTURE**

(30) Priority: 17.03.2025 ES 202530468 U
(71) Applicant: DR Representaciones S.L., 28500 Arganda del Rey (Madrid) (ES)
(72) Inventor: Fernández - Miranda Maeso, Juan Carlos, Arganda del Rey (Madrid (ES); de la Rosa Palomo, Santos, Arganda del Rey (Madrid) (ES)
(74) Representative: Pons IP

(57) **Abstract**

A rack cabinet with a removable internal structure, in other words, a cabinet comprising a base and a metal frame, which is designed primarily to house all the IT and telecommunications systems required by the businesses or organisations where it is installed.

A rack cabinet with a removable internal structure, comprising an outer metal frame or structure (1) within which at least one removable internal structure (5), consisting of an internal substructure (7) that slides relative to the outer metal frame or structure (1) by means of guide means, is removably housed.

## Description

### OBJECT OF THE INVENTION

The subject matter of this invention, as stated in the title, is a rack cabinet with a removable internal structure, in other words, a cabinet comprising a base and a metal frame, which is designed primarily to house all the information technology (IT) and telecommunications systems required by the businesses or organisations where it is installed.

The rack cabinet that is the subject of the invention is characterised by having at least one removable internal structure, which makes it easier to replace and handle IT equipment.

The present invention therefore falls within the field of rack cabinets for housing computer equipment.

### BACKGROUND OF THE INVENTION

It is common practice to use rack cabinets to house IT equipment such as servers, switches, professional routers, NAS and DAS servers, uninterruptible power supply (UPS) systems and, of course, all the network cabling required to provide the various services to the local network.

When computer equipment needs replacing, this requires crouching down or adopting rather awkward postures, as it is required to reach inside the cabinet to remove and, when appropriate, replace the equipment.

The aim of the present invention is therefore to develop a rack cabinet in which computer equipment is housed, allowing for the simple, easy and rapid replacement of said equipment, by developing a rack cabinet with a removable internal structure such as that which is described below and set out in its essential features in the first claim.

### DESCRIPTION OF THE INVENTION

The object of the present invention is essentially included in the independent claim, and the different embodiments are included in the dependent claims.

The present invention relates to a rack cabinet with a removable internal structure, comprising an outer metal frame or structure within which at least one removable internal structure, consisting of an internal substructure that slides relative to the outer metal frame or structure by means of guide means, is removably housed.

In one possible embodiment, the guide means for guiding the internal substructure relative to the outer metal frame or structure comprise guide rails attached to the outer metal frame or structure and telescopic slides attached at one end to the guide rails and at the opposite end to the internal substructure.

The extension length of the internal substructure relative to the outer frame or metal structure depends on the extendable length of the telescopic slides; this can be such that it allows, for example, the overhang of a table to be cleared when the rack cabinet is housed beneath a table.

The internal framework may consist of several trays, each of which can be individually removed.

Except when indicated otherwise, all of the technical and scientific elements used in this specification have the meaning commonly understood by a person with average skill in the art to which this invention belongs. When this invention is put into practice, methods and materials may be used that are similar or equivalent to the ones described in the specification.

Throughout the description and the claims, the word "comprise" and its variants are not intended to exclude other technical features, additions, components or steps. For those skilled in the art, other objects, advantages and features of the invention will be deduced from both the description and the practical use of the invention.

### DESCRIPTION OF THE FIGURES

As a complement to the description provided herein, and for the purpose of helping to make the features of the invention more readily understandable, in accordance with a preferred practical exemplary embodiment thereof, said description is accompanied by a set of drawings which, by way of illustration and not limitation, represent the following.
Figure 1 shows a perspective view of the rack cabinet that is the subject of the invention, with the access door closed.
Figure 2 shows a perspective view of the rack cabinet that is the subject of the invention, with the access door open.
Figure 3 shows the rack cabinet, where it can be observed that the removable internal structure has been taken out, allowing work to be carried out vertically, horizontally or using trays.

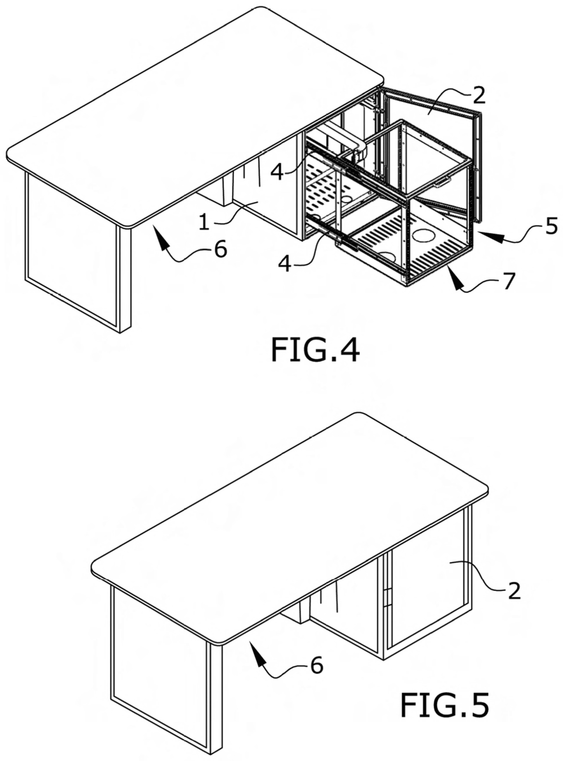

Figure 4 shows the relative position of the rack cabinet, which is the subject of the invention, in relation to a table top.
Figure 5 shows the rack cabinet housed beneath a table.
Figures 6 and 7 show a rack cabinet consisting of a number of trays arranged in parallel.
Figure 8 shows said rack cabinet with all the horizontal trays removed, wherein each tray can be individually removed.

### PREFERRED EMBODIMENT OF THE INVENTION

In light of the figures, a preferred embodiment of the proposed invention is described below.

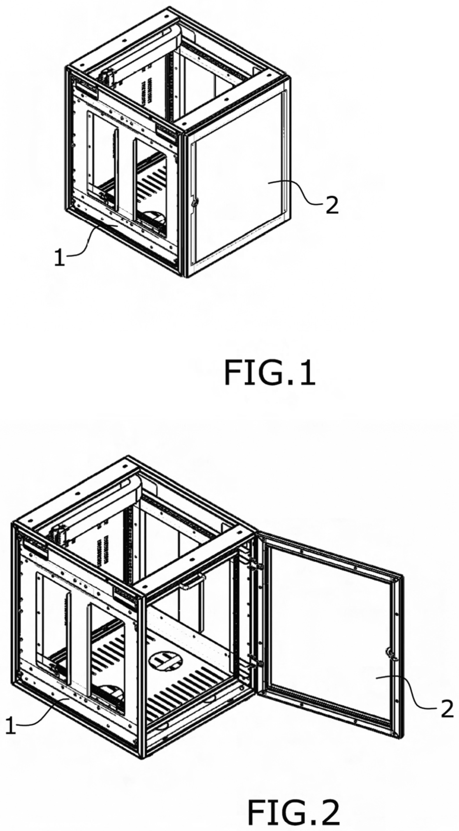

Figure 1 shows a rack cabinet with a removable structure, comprising an outer metal frame or structure (1), wherein the access door (2) closed, while Figure 2 shows the same cabinet with the access door (2) open.

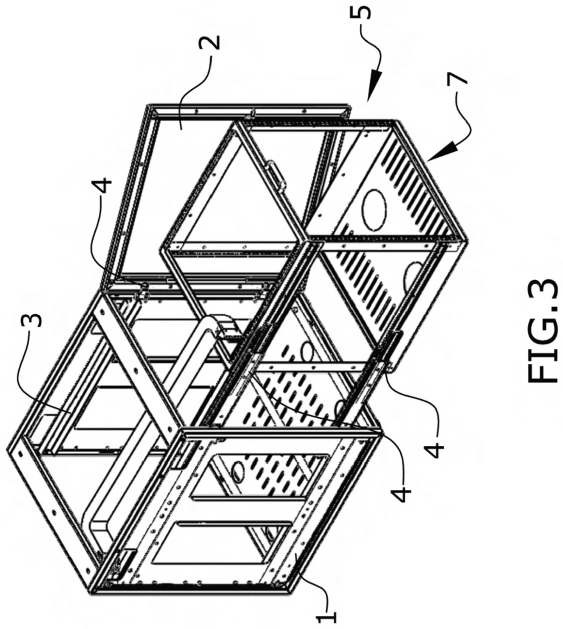

Figure 3 shows how a removable internal structure (5) is housed within the outer metal frame or structure (1); this internal structure consisting of an internal substructure (7) that slides relative to the outer metal frame or structure (1) by means of guide rails (3) attached to the outer metal frame or structure (1) and telescopic slides (4) attached at one end to the guide rails (3) and at the opposite end to the internal substructure (7).

The extent to which the internal substructure (7) can be withdrawn from the outer metal frame or structure (1) depends on the length to which the telescopic slides (4) can be extended, which, in one possible embodiment, may be such that the overhang (6) of the table top is cleared, so as not to interfere with the process of removing and replacing computer equipment.

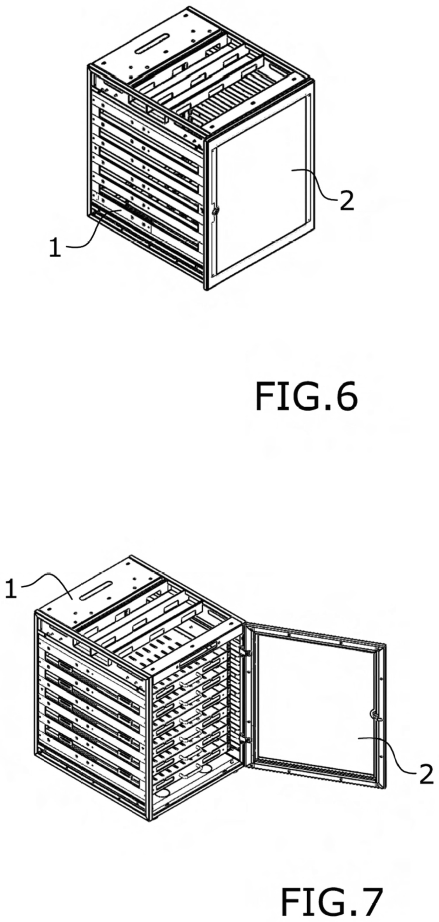

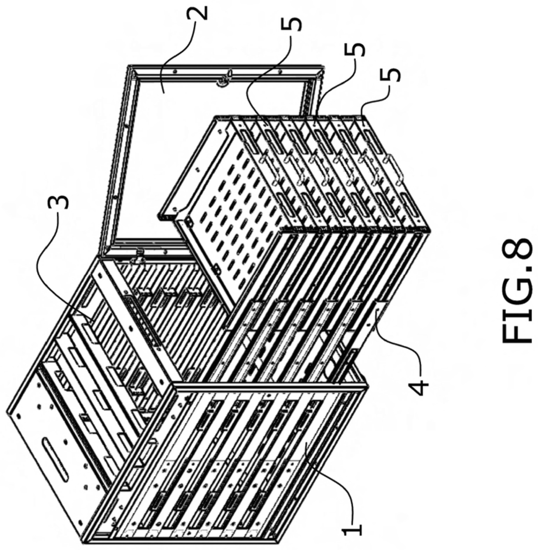

Figures 6 to 8 illustrate the same concept, except that instead of a single removable internal structure (5), there are multiple removable internal structures (5) by way of trays, each of which can be individually removed.

Having thus adequately described the nature of the present invention, as well as how to put it into practice, it must be noted that, within its essential nature, the invention may be carried out according to other embodiments differing in detail from that set out by way of example, which the protection sought would equally cover, provided that the fundamental principle thereof is not altered, changed or modified.

## Claims

1. A rack cabinet with a removable internal structure, **characterised in that** it comprises an outer metal frame or structure (1) within which at least one removable internal structure (5), consisting of an internal substructure (7) that slides relative to the outer metal frame or structure (1) by means of guide means, is removably housed.

2. The rack cabinet with a removable internal structure according to claim 1, **characterised in that** the guide means for guiding the internal substructure (7) relative to the outer metal frame or structure (1) comprise guide rails (3) attached to the outer metal frame or structure (1) and telescopic slides (4) attached at one end to the guide rails (3) and at the opposite end to the internal substructure (7).

3. The rack cabinet with a removable internal structure according to claim 1 or 2, **characterised in that** the rack cabinet has an access door (2) to the interior of the rack cabinet.
